# EUROPEAN PATENT SPECIFICATION

(11) **EP 0 439 751 B1**
(45) Date of publication and mention of the grant of the patent: **05.03.1997**
(21) Application number: 90124052.3
(22) Date of filing: 13.12.1990
(51) Int. Cl.: H01L 39/22, H01L 39/24

(54) **Superconductor gate field effect transistor**
Supraleitender Gatter-Feld-Effekt-Transistor
Transistor supraconducteur à grille isolée en effet de champ

(30) Priority: 01.02.1990 US 473292
(43) Date of publication of application: 07.08.1991
(73) Proprietor: International Business Machines Corporation, Armonk, N.Y. 10504 (US)
(72) Inventor: Chaudhari, Praveen, Briarcliff Manor, New York 10510 (US); Gambino, Richard Joseph, Yorktown Heights, New York 10598 (US); Koch, Roger Hilsen, Amawalk, New York 10501 (US); Laibowitz, Robert Benjamin, Peekskill, New York 10566 (US); Ganin, Eti, Peekskill, New York 10566 (US); Sai-Halasz, George Anthony, Mount Kisco, New York 10549 (US); Krusin-Elbaum, Lia, Dobbs Ferry, New York 10522 (US); Sun, Yuan-Chen, Katonah, New York 10536 (US); Wordeman, Matthew Robert, Mahopac, New York 10541 (US)
(74) Representative: Schäfer, Wolfgang, Dipl.-Ing.

(56) References cited:
- EP-A- 0 331 527
- PATENT ABSTRACTS OF JAPAN, vol. 13, no. 295 (E-783), 20th March 1989; & JP-A-1 074 758 (FUJITSU) 07-07-1989
- JOURNAL OF VACUUM SCIENCE & TECHNOLOGY A, vol. 7, no. 3, May 1989, pages 875-880, New York, US; J.M.E. HARPER et al.: "Mechanisms for success or failure of diffusion barriers between aluminum and silicon"
- APPLIED PHYSICS LETTERS, vol. 57, no. 3, 16th July 1990, pages 304-306 New York, US; Q.X. JIA et al.: "Sputter deposition of YBa2Cu307-x films on Si at 500 degrees C with conducting metallic oxide as a buffer layer"

## Description

The invention relates to field effect transistors of the type wherein the conductivity of a channel in a semiconductor body is affected by a charge on a gate positioned adjacent to that channel and to the improvement in circuit performance thereof through employing a high temperature superconductor material in the gate.

In the technology involving field effect transistors, as packing density and performance demands increase, the detracting effects of resistance and capacitance parasitics are being found to be serious in the type of field effect transistor (FET) having a metal or polysilicon gate. At the smallest dimensions, a quarter µm (micron) and smaller, the gate resistance becomes a serious detractor due to the RC time constant of the gate. In the metal-silicide gate FET, at small dimensions, the work function of typical metals limits performance. The choice of materials that can be employed in the gate is limited by requirements forced by the work function and compatibility with the processing techniques used in very large scale integrated circuits. It is also known that there are advantages in lower temperature of the order of 77°K operation and, in fact, it is accepted that there is about a 30% performance increase in the devices themselves. Further, with low temperatures, lower noise margins are encountered and lower voltages may be used. In the Patent Abstracts of Japan, vol. 13, no. 295 (E-783), 20th March 1989; JP-A-1 074 758 an insulated gate field effect transistor is described the gate of which is formed of a conductive film being in direct contact with the gate insulation and a superconductive film deposited on the conductive film.

The invention as claimed discloses the use of an oxide or ceramic superconductor material that is in the superconducting state in the gate of a FET provides improved performance through practical elimination of the RC time constant of the gate and the providing of a work function that allows convenient threshold control. In depletion mode FET devices, the proper work function permits operation at 77K. Oxide or ceramic superconductor materials are compatible with standard integrated circuit processing techniques and temperatures.

Embodiments of the invention are field effect transistor structures as claimed in claims 1 and 2.

Other advantageous embodiments of the inventive field effect structures are disclosed in the subclaims.

For a better understanding of the present invention, together with further objects and advantages, preferred embodiments of the invention are described in the following with reference to the accompanying drawings in which:
FIG. 1 is a top view of the superconductor gate field effect transistor of the invention.
FIG. 2 is a cross sectional view of the superconductor gate field effect transistor of the invention.
FIGS. 3 and 4 are cross sectional views of FET gate structures with different properties employed in the invention.
FIG. 5 is a cross sectional view of a CMOS structure employing the invention.
FIG. 6 is a cross section of an enhancement-depletion (E/D) FET structure employing the invention.

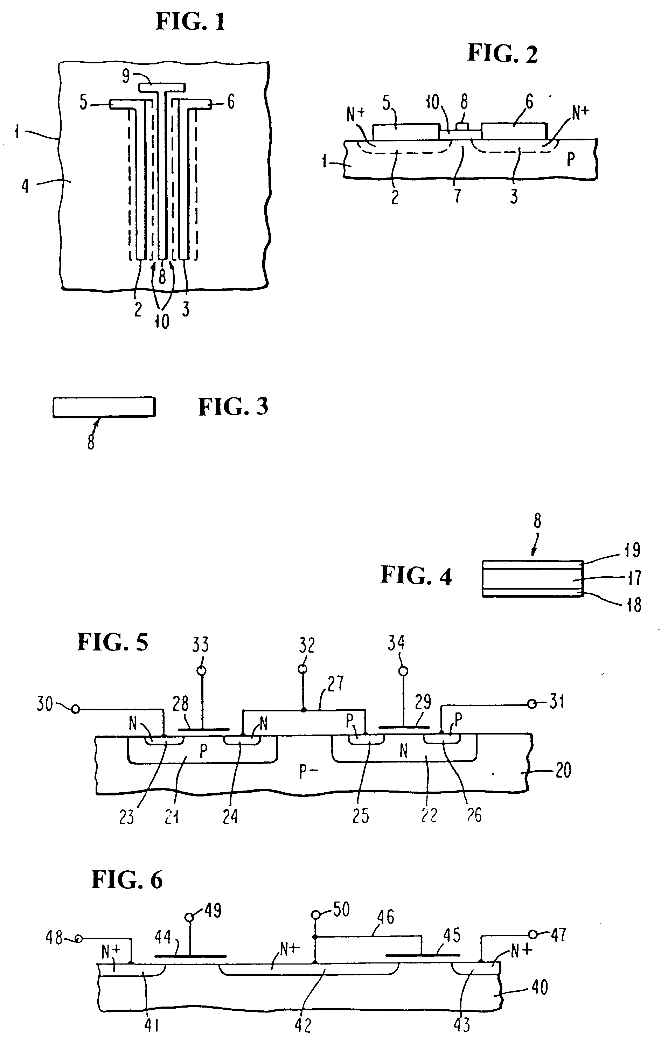

Referring to FIG. 1, in a top view, a field effect transistor (FET) is positioned in a semiconductor substrate 1 of, for example, p conductivity type silicon. Source 2 and drain 3 N⁺ conductivity regions are embedded in the substrate 1, with the high doping shown in dotted outline and the respective contacts on the surface 4 shown as 5 and 6. The area between the source 2 and the drain 3 is the channel 7. In the narrow space between the source 2 and the drain 3, a gate 8 extending to a contact 9 is positioned over a gate insulator 10 that in turn is over the channel 7. In this type of structure, the RC time constant of the long narrow gate 8 is a serious detractor to performance.

In accordance with the invention, the gate 8 is of superconductor material that is superconductive at the temperature of operation.

Referring to FIG. 2, in a cross sectional view, in the substrate 1, the source 2 and drain 3 high conductivity N⁺ regions are in the substrate 1 with the contacts 5 and 6 extending above. The channel 7 is in the substrate 1 between the source 2 and the drain 3. The superconductor gate 8 is positioned between the source 2 and drain 3 separated from the channel 7 by the gate insulator 10.

In operation, a charge on the gate 8 operates to change the current flowing between the source 2 and the drain 3.

In accordance with the invention, the gate 8 contains an oxide superconducting material that is in the superconducting state. The gate 8 may be all oxide superconductor as shown in FIG. 3, and the gate 8 may have a layer 17 of an oxide superconductor between layers 18 and 19 of a material selected for further work function adjustment as shown in FIG. 4.

The purpose of the structure of FIG. 4 is to facilitate device threshold adjustment. The superconducting material has the well known property of zero resistance with accompanying low parasitic capacitance resulting from small cross sectional area made possible by the high conductance. These features allow small interelectrode separation and correspondingly high density. Further, since the oxide superconductor has ceramic properties, it is rendered superconducting by a firing or deposition step at greater than approximately 650°C and, thereafter, will withstand prolonged high temperatures. This results in a broad "process window" or temperature cycle production tolerance so that it can be applied early in the manufacturing operation and not be influenced by later processing events.

The most studied oxide superconducting material is a class of compounds known in the art as 1-2-3 compounds with the general formula Y₁Ba₂Cu₃O_{7-y} where y is approximately 0.1, which have transition temperatures to the superconducting state as high as 94°K. The transition temperature can be maintained where the yttrium (Y) is replaced by such rare earths as europium, gadolinium, neodymium, etc.

There are families of other compounds, for example, one of bismuth, strontium, calcium, copper and oxygen with a transition temperature of approximately 108°K; another of thallium, strontium, calcium, copper and oxygen with a transition temperature of approximately 125°K and still another of lanthanum, strontium, copper and oxygen with a transition temperature of approximately 37°K. A discussion of families of superconducting compounds is presented in the Materials Research Society, MRS Bulletin, Volume XIV, No. 1, January 1989, pages 45 to 48.

The oxide superconductor material may be applied by a variety of vapor deposition techniques. Examples of these techniques are discussed in Materials Research Society, MRS Bulletin, Volume XIV, No. 1, January 1989, pages 58-62.

A valuable feature of the oxide superconductor is the work function which is the energy required to remove an electron from the material.

In general, a combination of materials with different work functions result in a work function within the range defined by the extreme work functions of the constituents. For example, for the 1-2-3 compound of Y₁Ba₂Cu₃O_{7-y}, the Y₂O₃ constituent exhibits a work function of about 2 eV, the BaO constituent exhibits a work function of about 1.6 eV and the CuO constituent exhibits a work function of about 4.1 eV so that the work function would be expected to be higher than about 1.6 eV and lower than about 4.1 eV.

It has also been shown that there is a relationship between electronegativity and work function. There is a discussion in the IBM Journal of Research and Development, Vol. 22, No. 1, January 1978, pages 72-80.

The principles of the invention are useful for enhancement mode devices, for N conductivity type channel (NMOS) devices, for P conductivity type (PMOS) devices and for complementary n and p (CMOS) type circuits. It is also useful for N and P conductivity type depletion mode devices. In many structures, more than one type device is included in the same substrate.

It is desirable to have the threshold voltage of a depletion mode FET with an n-channel to be negative. Where the work function of the gate is large, of the order of 4.0 eV, as occurs with a metal gate such as Al or with n doped polysilicon it is necessary to counterdope the channel region 7 to cause the threshold voltage to be negative. Such structures, however, at 77°K or lower, do not operate properly due to carrier freezeout in the counterdoped channel region which in turn causes a shift in threshold or turn off voltage in the device.

It will be apparent to one skilled in the art that for a depletion mode p channel, the channel will be doped p and a high work function gate employed. The higher work function can be achieved by the type of gate structure of FIG. 4.

The combination of the gate 8 of the oxide superconductor with work function control materials provides more precise threshold for turn-on resulting in reduced delays and better sub-threshold behavior in normally off devices.

In FIG. 4, further control of gate work function is illustrated. In FIG. 4, the gate 8 is made up of a layer 17 of oxide superconductor between a lower electrode layer 18 of a conducting oxide, such as Ruthenium Oxide (RuO₂), that has a work function in the 4.6 to 8.0 eV range, about mid bandgap of the Si semiconductor 1 and a covering electrode layer 19 which may be of the same material. The lower electrode layer 18 is positioned on the insulating oxide layer 10. The RuO₂ is stable, is a good conductor with a resistivity about 30 micro ohm-centimeter. It is an excellent diffusion barrier. The RuO₂ may be annealed in oxygen and does not degrade.

The structure of FIG. 4 may be prepared by sputtering a 5 to 50 nanometer thick layer 18 of RuO₂ on the gate insulator 10, followed by a 150-300 nanometer thick layer of oxide superconductor 17. Patterning of the gate can be performed using, for example, HNO₃:H₂O (3:7) solution as a chemical etch, or by ion milling. A capping layer 19 of, for example, 5-50 nanometers thick RuO₂ can also be added by depositing on the layer 17. Layer 19 provides electrical contact to,as well as environmental protection and stability for,the oxide superconductor 17.

The principles of the invention in gate work function adjustability are particularly useful in FET structures where devices are in a common substrate. The superconductor favorable work function may be used alone, adjusted, combined with channel doping or used to eliminate the need for some types of channel doping in these structures in operation mode and threshold selection.

Referring next to FIG. 5, an illustration of the invention is shown applied to one example of the CMOS type structure. In FIG. 5, the CMOS structure is made in a substrate 20 of, for example, p conductivity type silicon in which two p and n conductivity type wells 21 and 22, respectively, are positioned. In well 21, N⁺ source 23 and drain 24 electrodes are positioned. Correspondingly, in well 22, P⁺ source 25 and drain 26 electrodes are positioned. The elements 24 and 25 are electrically joined by element 27. A superconducting gate 28 is provided for the device in well 21 and a superconducting gate 29 is provided for the device in well 22. A conductor 30 serves as a power connection, a conductor 31 serves as a ground or reference connection, the output is at terminal 32 connected to element 27 and the inputs are at terminals 33 and 34 connected to gates 28 and 29, respectively. The superconducting gates 28 and 29 have resistance, capacitance and work function benefits as described in connection with FIGS. 3 and 4.

Referring next to FIG. 6, an illustration of the invention as applied to an enhanced-depletion (E/D) FET circuit structure is shown. In FIG. 6, the structure is made in a substrate 40 of, for example, p conductivity type silicon having three N⁺ conductivity type electrodes 41, 42 and 43, respectively, in one surface. The electrode 42 serves as a common electrode separated by a channel from electrode 41 on one side and another channel from electrode 43 on the other side. A first superconductor gate 44 is positioned over the channel between electrodes 41 and 42 and a second superconductor gate 45 is positioned over the channel between electrodes 42 and 43. The electrode 42 and the gate 45 are electrically joined by conductor 46. A conductor 47 serves as a power connection, a conductor 48 serves as a ground connection, a terminal 49 connected to the first gate 44 serves as the input and the terminal 50 connected to element 46 serves as the output. In the structure of FIG. 6, the gates have the resistance, capacitance and work function benefits as described in connection with FIGS. 3 and 4. In E/D devices, such as that of FIG. 6, the favorable work function of the superconductive gate of the invention makes possible a naturally negative threshold level for one device while using standard techniques to establish a precise turn-on level for the other device and also makes possible eliminating the need for channel counterdoping in the depletion mode transistor.

What has been described is an FET transistor in which operation is below the T_{c} of a superconductor gate in the transistor.

## Claims

1. A field effect transistor structure comprising in combination:
a semiconductor substrate (1) of a first conductivity type having in one surface zone thereof first and second highly doped regions (2, 3) of conductivity type opposite to the first conductivity type separated by a channel (7), an insulating layer (10) on the surface covering said channel (7) and on the insulating layer (10) a gate member (8) containing a superconducting oxide superconductor characterized by
said gate member (8) of superconducting oxide superconductor being in direct contact with said insulating layer (10) with the gate work function being controlled by the selection among the various superconducting oxides.

2. A field effect transistor structure comprising in combination:
a semiconductor substrate of a first conductivity type having in one surface zone thereof first and second highly doped regions (2, 3) of conductivity type opposite to the first conductivity type separated by a channel (7), an insulating layer (10) on the surface covering said channel (7) and a gate member (8) containing a superconducting oxide superconductor (17)and a conductive layer (18) being adjacent said insulating layer (10) and underlying said superconductor (17)characterized in that,
said gate member (8) is made up of said layer (17) of oxide superconductor material and - for the control of the gate work function - of said conductive layer (18) consisting of ruthenium oxide and of a covering electrode layer (19) which may be of ruthenium oxide, overlying said layer (17).

3. A field effect transistor structure of the type having first and second gates (28, 29 or 44, 45), each controlling a channel in a common substrate characterized in that:
said gates (28, 29 or 44, 45) are structured as disclosed in claim 1 or 2 and overlaying a gate insulating layer.

4. The field effect transistor structure of claim 3, wherein the work functions of said first and second gates (28, 29 or 44, 45) differ.

5. The field effect transistor structure of any one of claims 1 to 4 wherein the operation mode and threshold in each said channel is provided by at least one of a combination of the work function of said superconducting gate (8; 28, 29 or 44, 45), the adjustment of the work function of said superconducting gate (8; 28, 29 or 44, 45), and doping in the channel controlled by said gate (8; 28, 29 or 44, 45).

6. The field effect transistor structure of claim 5 wherein two said field effect transistors are in said common substrate (20, 40) and said means for controlling threshold and operation mode produces enhancement mode operation in one channel and depletion mode operation in the other channel.

7. The field effect transistor structure of any one of claims 3 to 6 wherein two said field effect transistors are in said common substrate (20) with one being of the p channel type.

8. The field effect transistor structure of any one of the preceding claims wherein the superconductor material of said gate electrode (8; 28, 29 or 44, 45) is a material taken from the group of: a compound of yttrium, barium, copper and oxygen; a compound of thallium, strontium, calcium, copper and oxygen; a compound of bismuth, strontium, calcium,copper and oxygen; and a compound of lanthanum, strontium, copper and oxygen.

9. The field effect transistor structure of any one of the preceding claims 1 to 8 wherein said superconductor material is of the family of 1-2-3 compounds in the general formula Y₁Ba₂Cu₃O_{7-y} where y is approximately 0.1.

10. The field effect transistor structure of any one of the preceding claims being operative at a temperature below the T_{c} of said superconducting material.

11. The field effect transistor structure of any one of the preceding claims wherein said gate member (8; 28, 29 or 44, 45) is longer in the direction transverse to the distance of said channel between said source and said drain electrodes (2, 3; 23, 24; 25, 26; 41, 42 or 42, 43) than along said distance of said channel.

## Patentansprüche

1. Eine Feld-Effekt-Transistor-Struktur, die in Kombination folgendes enthält:
ein Halbleiter-Substrat (1) eines ersten Leitfähigkeitstyps, das in einer Oberflächenzone erste und zweite hochdotierte Bereiche (2, 3) aufweist, mit einem Leitfähigkeitstyp, der dem ersten Leitfähigkeitstyp entgegengesetzt ist, getrennt durch einen Kanal (7), eine Isolierschicht (10) auf der den genannten Kanal (7) abdeckenden Oberfläche, und ein Gatterelement (8) auf der Isolierschicht (10), das einen supraleitenden Oxid-Supraleiter enthält, gekennzeichnet dadurch, daß
das genannte Gatterelement (8) des supraleitenden Oxid-Supraleiters sich in direktem Kontakt mit der genannten Isolierschicht (10) befindet, wobei die Gatter-Austrittsarbeit gesteuert wird durch die Auswahl zwischen den verschiedenen supraleitenden Oxiden.

2. Eine Feld-Effekt-Transistor-Struktur, die in Kombination folgendes enthält:
ein Halbleiter-Substrat eines ersten Leitfähigkeitstyps, das in einer Oberflächenzone erste und zweite hochdotierte Bereiche (2, 3) mit einem Leitfähigkeitstyp umfaßt, der entgegengesetzt zu dem ersten Leitfähigkeitstyp ist, getrennt durch einen Kanal (7), eine Isolierschicht (10) auf der den genannten Kanal (7) bedeckenden Oberfläche, und ein Gatterelement (8), das einen supraleitenden Oxid-Supraleiter (17) und eine leitende Schicht (18) umfaßt, die an die genannte Isolierschicht (10) angrenzen und unter dem genannten Supraleiter (17) liegen, dadurch gekennzeichnet, daß
das genannte Gatterelement (8) aus der genannten Schicht (17) von Oxid-Supraleitermaterial besteht und - zur Kontrolle der Austrittsarbeit des Gatters - aus der genannten leitenden Schicht (18), bestehend aus Rutheniumoxid, und aus einer abdeckenden Elektrodenschicht (19), die aus Rutheniumoxid bestehen kann und die genannte Schicht (17) überdeckt.

3. Eine Feld-Effekt-Transistor-Struktur des Typs mit einem ersten und einem zweiten Gatter (28, 29 oder 44, 45), wobei jedes einen Kanal in einem gemeinsamen Substrat steuert, dadurch gekennzeichnet, daß:
die genannten Gatter (28, 29 oder 44, 45) so strukturiert sind, wie in Anspruch 1 oder 2 beschrieben wurde, und über einer Gatterisolierschicht liegen.

4. Die Feld-Effekt-Transistor-Struktur nach Anspruch 3, bei der die Austrittsarbeit der genannten ersten und zweiten Gatter (28, 29 oder 44, 45) unterschiedlich ist.

5. Die Feld-Effekt-Transistor-Struktur nach einem jeden der Ansprüche 1 bis 4, bei der der Betriebsmodus und die Schwelle in jedem der genannten Kanäle zumindest von einer der folgenden Kombinationen bereitgestellt wird, nämlich von der Austrittsarbeit des genannten supraleitenden Gatters (8; 28, 29 oder 44, 45), der Anpassung der Austrittsarbeit des genannten supraleitenden Gatters (8; 28, 29 oder 44, 45) und einer Dotierung in dem durch das genannte Gatter (8; 28, 29 oder 44, 45) gesteuerten Kanal

6. Die Feld-Effekt-Transistor-Struktur nach Anspruch 5, bei der zwei der genannten Feld-Effekt-Transistoren sich in dem genannten gemeinsamen Substrat (20, 40) befinden und das genannte Mittel zur Steuerung der Schwelle und des Betriebsmodus einen Anreicherungsbetrieb in dem einen Kanal und einen Verarmungsbetrieb in dem anderen Kanal erzeugt.

7. Die Feld-Effekt-Transistor-Struktur nach einem jeden der Ansprüche 3 bis 6, bei der zwei der genannten Feld-Effekt-Transistoren sich in dem genannten gemeinsamen Substrat (20) befinden, wobei einer ein p-Kanal-Typ ist.

8. Die Feld-Effekt-Transistor-Struktur nach einem jeden der vorangehenden Ansprüche, bei der das Supraleitermaterial der genannten Gatterelektrode (8; 28, 29 oder 44, 45) ein Material aus der folgenden Gruppe ist: eine Verbindung aus Yttrium, Barium, Kupfer und Sauerstoff; eine Verbindung aus Thallium, Strontium, Kalzium, Kupfer und Sauerstoff; eine Verbindung aus Wismut, Strontium, Kalzium, Kupfer und Sauerstoff; und eine Verbindung aus Lanthan, Strontium, Kupfer und Sauerstoff.

9. Die Feld-Effekt-Transistor-Struktur nach einem jeden der vorangehenden Ansprüche 1 bis 8, bei der das genannte Supraleitermaterial aus der Familie der 1-2-3-Verbindungen der allgemeinen Formel Y₁Ba₂Cu₃O_{7-y} stammt, wobei y etwa 0,1 ist.

10. Die Feld-Effekt-Transistor-Struktur nach einem jeden der vorangehenden Ansprüche, die bei einer Temperatur unter der T_{c}-Temperatur des genannten supraleitenden Materials arbeitet.

11. Die Feld-Effekt-Transistor-Struktur nach einem jeden der vorangehenden Ansprüche, bei der das genannte Gatterelement (8; 28, 29 oder 44, 45) in der Richtung quer zum Abstand des genannten Kanals zwischen der genannten Quellen- und der genannten Senkenelektrode (2, 3; 23, 24; 25, 26; 41, 42 oder 42, 43) länger ist, als entlang der genannten Distanz des genannten Kanals.

## Revendications

1. Structure de transistor à effet de champ comprenant en combinaison:
un substrat semi-conducteur (1) d'un premier type de conductivité ayant dans une zone à sa surface des première et deuxième régions fortement dopées (2, 3) de type de conductivité opposé au premier type de conductivité séparées par un canal (7), une couche isolante (10) sur la surface revêtant ledit canal (7) et, sur la couche isolante (10), un élément de porte (8) contenant un supraconducteur d'oxyde supraconducteur,
caractérisée par
ledit élément de porte (8) de supraconducteur d'oxyde supraconducteur qui est en contact direct avec ladite couche isolante (10), le travail de sortie de la porte étant commandé par la sélection parmi les divers oxydes supraconducteurs.

2. Structure de transistor à effet de champ comprenant en combinaison:
un substrat semi-conducteur d'un premier type de conductivité ayant dans une zone à sa surface des première et deuxième régions fortement dopées (2, 3) de type de conductivité opposé au premier type de conductivité séparées par un canal (7), une couche isolante (10) sur la surface revêtant ledit canal (7), et un élément de porte (8) contenant un supraconducteur d'oxyde supraconducteur (17) et une couche conductrice 18 adjacente à ladite couche isolante (10) et sous-jacente audit supraconducteur (17),
caractérisée en ce que
ledit élément de porte (8) est constitué de ladite couche (17) de matériau supraconducteur d'oxyde et - pour la commande du travail de sortie de la porte - de ladite couche conductrice (18) faite d'oxyde de ruthénium, et d'une couche d'électrode de revêtement (19) qui peut être de l'oxyde de ruthénium, revêtant ladite couche (17).

3. Structure de transistor à effet de champ du type ayant des première et deuxième portes (28, 29 ou 44, 45), chacune commandant un canal dans un substrat commun,
caractérisée en ce que
lesdites portes (28, 29 ou 44, 45) sont structurées de la façon décrite dans les revendications 1 ou 2 et revêtant une couche isolante de porte.

4. Structure de transistor à effet de champ selon la revendication 3, dans laquelle le travail de sortie desdites première et deuxième portes (28, 29 ou 44, 45) diffère.

5. Structure de transistor à effet de champ selon l'une quelconque des revendications précédentes 1 à 4, dans laquelle le mode d'opération et le seuil dans chacun desdits canaux sont assurés par au moins une d'une combinaison de travail de sortie de ladite porte supraconductrice (8; 28, 29 ou 44, 45), du réglage du travail de sortie de ladite porte supraconductrice (8; 28, 29 ou 44, 45), et du dopage dans le canal commandé par ladite porte (8; 28, 29 ou 44, 45).

6. Structure de transistor à effet de champ selon la revendication 5, dans laquelle deux dits transistors à effet de champ sont dans ledit substrat commun (20, 40) et ledit moyen pour commander le seuil et le mode d'opération produit une opération en mode d'enrichissement dans un canal et une opération en mode d'appauvrissement dans l'autre canal.

7. Structure de transistor à effet de champ selon l'une quelconque des revendications 3 à 6, dans laquelle deux dits transistors à effet de champ sont dans ledit substrat commun (20), l'un étant du type de canal p.

8. Structure de transistor à effet de champ selon l'une quelconque des revendications précédentes, dans laquelle le matériau supraconducteur de ladite électrode de porte (8; 28, 29 ou 44, 45) est un matériau extrait du groupe de: un composé d'yttrium, de baryum, de cuivre et d'oxygène; un composé de thallium, de strontium, de calcium, de cuivre et d'oxygène; un composé de bismuth, de strontium, de calcium, de cuivre et d'oxygène; et un composé de lanthane, de strontium, de cuivre et d'oxygène.

9. Structure de transistor à effet de champ selon l'une quelconque des revendications précédentes 1 à 8, dans laquelle ledit matériau supraconducteur est de la famille des composés 1-2-3 dans la formule générale Y₁Ba₂Cu₃O_{7-y}, où Y est approximativement 0,1.

10. Structure de transistor à effet de champ selon l'une quelconque des revendications précédentes, pouvant fonctionner à une température inférieure à la température T_{c} dudit matériau supraconducteur.

11. Structure de transistor à effet de champ selon l'une quelconque des revendications précédentes, dans laquelle ledit élément de porte (8; 28, 29 ou 44, 45) est plus long dans la direction transversale à la distance dudit canal séparant ladite électrode de source et ladite électrode de drain (2, 3; 23, 24; 25, 26; 41, 42 ou 42, 43) que le long de ladite distance dudit canal.
